# EUROPEAN PATENT SPECIFICATION

(11) **EP 4 571 839 B1**
(45) Date of publication and mention of the grant of the patent: **04.11.2026**
(21) Application number: 23216437.6
(22) Date of filing: 13.12.2023
(51) Int. Cl.: H10D 30/47, H10D 62/10, H10D 64/00, H10D 64/23, H10D 62/17, H10D 62/85

(54) **III-V SEMICONDUCTOR DEVICE**
III-V HALBLEITERANORDNUNG
DISPOSITIF A SEMI-CONDUCTEUR III-V

(43) Date of publication of application: 18.06.2025
(73) Proprietor: Infineon Technologies Austria AG, 9500 Villach (AT)
(72) Inventor: HAEBERLEN, Oliver, 9524 Villach (AT); PRECHTL, Gerhard, 9232 Rosegg (AT)
(74) Representative: JENSEN & SON

(56) References cited:
- CN-B- 112 331 719
- US-A1- 2017 301 781
- US-B1- 11 152 474
- N. RONCHI: "Optimization of the source field-plate design for low dynamic R DS-ON dispersion of AlGaN/GaN MIS-HEMTs", vol. 214, no. 3, 1 March 2017 (2017-03-01), DE, XP093155867, ISSN: 1862-6300, Retrieved from the Internet <URL:https://api.wiley.com/onlinelibrary/tdm/v1/articles/10.1002%2Fpssa.201600601> DOI: 10.1002/pssa.201600601

## Description

### BACKGROUND

To date, transistors used in power electronic applications have typically been fabricated with silicon (Si) semiconductor materials. Common transistor devices for power applications include Si CoolMOS^{®}, Si Power MOSFETs, and Si Insulated Gate Bipolar Transistors (IGBTs). More recently, silicon carbide (SiC) power devices have been considered. Group III-N semiconductor devices, such as gallium nitride (GaN) devices, are now emerging as attractive candidates to carry large currents, support high voltages and to provide very low on-resistance and fast switching times.

Published US patent application US 2012/0175631 A1 describes an enhancement mode Group III nitride High Electron Mobility Transistor (HEMT) comprising a source contact, a drain contact and a gate. The gate comprises a gate metal on a p-type GaN or p-type AlGaN material and a gate spacer material arranged on the side faces of the gate metal. This HEMT also comprises a source ohmic metal layer that extends over the gate towards the drain and that is used as a field plate to relieve the electric field at the gate corner facing the drain contact, lower the gate leakage current and improve the gate reliability.

US 2017/301781 A1 describes a HEMT having a lateral geometry having a gate, gate-connected field plate, as well as a stacked source electrode comprising a source contact, a field plate and a power metal located directly on top of the field plate where the field plate extends over the gate electrode. The power metal however, does not extend over the gate electrode.

The article "Optimisation of the source field-plate design for low dynamic R DS-ON dispersion of AlGaN MIS-HEMTS" PHYSICA STATUS SOLIDI. A: APPLICATIONS AND MATERIALS SCIENCE, vol. 214, no. 3, 1 March 2017 N. Ronchi describes AlGaN/GaN MIS-HEMTs with two levels of source field-plates extending over a gate electrode as well as a power metal located directly on the field plate. The power metal does not extend over the gate electrode.

CN 112 331 719 B describes a semiconductor device includes first and second nitride semiconductor layers, a source, a drain, a gate structure, a first p-type doped nitride semiconductor bump, and a plurality of second p-type doped nitride semiconductor bumps.

US 11 152 474 B1 describes a semiconductor device including a substrate, a gate electrode, a first dielectric layer, a source field plate, a second dielectric layer, a source electrode and a drain electrode.

It is desirable to further improve the performance of Group III nitride devices.

### SUMMARY

The invention is summarized by the appended set of claims.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other.

Exemplary embodiments are depicted in the drawings and are detailed in the description which follows.
Fig. 1 illustrates a semiconductor device according to an embodiment.
Fig. 2 illustrates a semiconductor device according to an embodiment.
Fig. 3 illustrates a semiconductor device according to an embodiment.
Fig. 4 illustrates a semiconductor device according to an embodiment.
Fig. 5 illustrates a semiconductor device according to an embodiment.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made.

The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

A depletion-mode device has a negative threshold voltage which means that it can conduct current at zero gate voltage. These devices are normally on. An enhancement-mode device has a positive threshold voltage which means that it cannot conduct current at zero gate voltage and is normally off.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐP_{b}N_{(1-a-b)}), for example. The terms Aluminum gallium nitride and AlGaN refer to a ternary alloy described by the formula AlₓGa₍₁₋ₓ₎N, where 0 < x < 1.

Group III nitride-based devices, such as p-GaN gate power HEMTs, have been commercialized with good performance. However, due to the lateral device structure of such Group III nitride-based devices and the high electric fields allowed in wide band gap semiconductors, it is expected that the dielectrics of the device which are, for example, used in the passivation and metallization structure, may be subjected to a higher stress during blocking compared to vertical silicon-based power devices.

In power devices, the power metallization is used for field plate constructions. Due to processing issues, undesirable variations in these field plates may result. One issue that is identified and addressed herein is the variation in the position of the field plate edge. For thick power metallization layers, e.g. 4um thickness, a typical minimum metal width is in the range of 4µm. Due to the subsequent structuring of the power metal, a typical line width tolerance of +/- 10% is common. In this particular case, the distance between the gate foot and the field plate edge could vary by at least +/-400nm (neglecting the alignment tolerance and the structuring tolerance of the gate). This variation in the field plate edge position with respect to the gate foot leads to a variation of the electric fields within the dielectrics located below the field plate as well to variations in the electric field distribution within the GaN transistor itself. The difference in electrical field distribution between different devices leads to leakage variations between different devices. These leakage variations also result in the screening of bad parts using PAT (Part Average Testing) techniques, which are used to detect and remove outlier devices, becoming challenging. Furthermore, the different electrical field distributions within the device due to the variation of the field plate edge creates difficulties in a unified electrical screening procedure, which makes the detection of weak parts / defective parts difficult.

To reduce the variation of the field plate edge position, it is proposed to include a thin metal liner below the power metal. The thickness of this thin metal liner is less than the thickness of the power metal, e.g. the metal liner may have a thickness in the range of 100nm, whereas the power metal may have a thickness of at least 0,3 µm or at least 1 µm or 4 µm or more. The thickness of the power metal may depend on the deposition method. This thin liner can be structured very accurately, for example, with a tolerance of max. +/- 100nm. The power metal is placed above the liner in such a way that the power metal does not overlap at least a distal portion of the liner. The edge of the field plate is defined by the protruding distal portion of the underlying liner instead of the power metal itself. With this stack, a field plate construction is provided in which the distance variations between the gate foot and the outermost field plate edge, i.e. the edge of the distal portion of the liner layer, is reduced.

Instead of a single power metal, a power metal stack is used. The power metal stack comprises the thinner metal liner below the thicker power metal material. The power metal field plate is designed so that the field plate edge is defined by the underlying thin metal liner and the real power metal, that carries the majority of the current, is placed above the liner in such a way that the power metal does not overlap or extend over the liner edge. With this construction the field plate edge variation is determined by the structuring of the thin liner, which is much more accurate compared to that achieved when structuring the thick power metal.

Instead of a single material liner also a dual liner can be used, for example Ti/TiN. This material combination can be used to provide a better adhesion of the liner metal layer to oxide / nitride dielectrics.

This field plate construction can be used for the source contact or the drain contact or both of a transistor device, for the anode and/or cathode of a diode, or for one or both power contacts of a bidirectional switch. In the case of the drain contact, the thinner liner should extend into the access region between gate and drain. The transistor device may be a depletion mode or enhancement mode device. In an embodiment, the transistor device is a HEMT. The drain of the transistor device may be a hybrid drain and include an electrode and p-type Group III nitride region arranged between the electrode and gate. The p-type Group III nitride region is electrically connected to the electrode. The liner extends from the electrode over the p-type Group III nitride region and into the access region between the p-type Group III nitride region and the gate.

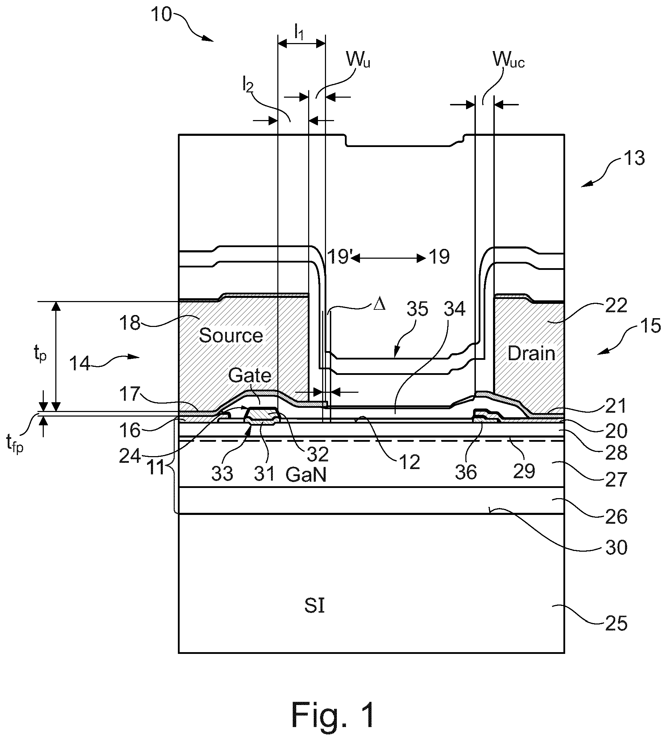

Figure 1 illustrates a semiconductor device 10 which comprises a Group III nitride-based body or substrate 11 having a first major surface 12. A lateral Group III nitride-based device 13 is formed in the Group III nitride-based substrate 11 and comprises a first power contact 14 and a second power contact 15 which are arranged on the first major surface 12

The first power contact 14 comprises an electrode 16 which is arranged on the first major surface 12, a field plate 17 which is arranged on the electrode 16 and a power metallic layer 18 which is arranged directly on the field plate 17. No conductive via, that is formed separately from the power metallic layer 18, is present between the power metallic layer 18 and the field plate 17. The electrode 16, the field plate 17 and the power metallic layer 18 may each comprise a metal or an alloy. The field plate 17 has a lateral extent in a first direction 19, the first lateral direction 19 extending parallel to the first major surface 12. The field plate 17 may extend in the first direction 19 and parallel to the first major surface 12 or may extend in the first direction 19 and at an inclined angle to the first major surface 12, for example, the field plate 17 may be slanted. In this embodiment, the first direction 19 extends from the first power contact 14 towards the second power contact 15. The lateral extent of the field plate 17 in the first direction 19, is referred to as the width of the field plate 16 and is greater than a lateral extent of the electrode 16 in this first direction 19. The power metallic layer 18 has a lateral extent in the first direction 19 that is less than the lateral extent of the field plate 17 in the first direction 19. As a consequence, a distal end of the field plate 17 protrudes from and is uncovered by the power metallic layer 18.

The power metallic layer 18 has a thickness tₚ, the thickness being defined as the direction perpendicular to the first major surface 12. The thickness tₚ of the power metallic layer 18 is greater than the thickness t_{fp} of the field plate 17. In some embodiments, the thickness t_{fp} of the field plate 17 may also be greater than the thickness of the electrode 16.

In an embodiment, the power metallic layer 18 has a thickness tₚ, wherein 0.3 µm ≤ tₚ ≤ 4 µm and/or the field plate 17 has a thickness t_{fp} and 75 nm ≤ t_{fp} ≤ 500 nm. Alternatively, 10 nm ≤ t_{fp} ≤ 500 nm or 10 nm ≤ t_{fp} ≤ 300 nm or 75 nm ≤ t_{fp} ≤ 125 nm.

In an embodiment, the peripheral portion of the field plate 17 that is uncovered by the power metallic layer has a width wᵤ, wherein wᵤ ≥ 0.1tₚ or wᵤ ≥ 0.2tₚ or wᵤ ≥ 0.3tₚ, and 0.3 µm ≤ tₚ ≤ 4 µm. In other words, the spacing between the power metallic layer 18 and the edge of the field plate 17 is at least 10% of the thickness tₚ of the power metallic layer 18.

At least the peripheral or distal end portion of the field plate 17 with the width wᵤ extends beyond a lateral extent of the gate electrode 24 in the first direction 19 by a distance I₁, wherein. l₁ > 0.1 tₚ. In an embodiment l₁ ≥ 0.5 tₚ.

The power metallic layer 18 extends beyond the lateral extent of the gate electrode 24 in the first direction 19 by a distance l₂, wherein l₂ < l₁.

The variation of the position of the edge of the field plate 17 in the first direction 19 that is caused by processing, e.g. by structuring of the photolithographic masks and etching of the underlying layer to form the field plate 17 from a continuous closed layer, is indicated in Figure 1 with Δ. Since the field plate 17 has a small thickness this variation Δ is less than the variation that typically arises when structuring a thicker layer, e.g. the power metallic layer 18. Consequently, the position of the edge of the field plate 17 is more reliably achieved for different devices. This has the advantage that a field plate construction is provided in which the distance variations between the foot of the gate 24 and the outermost edge of the field plate'16 17, i.e. the edge of the distal portion of the field plate 17, is reduced. By reducing the variation in the field plate edge position with respect to the gate foot, the variation in the electric fields within the dielectrics located below the field plate 17, e.g. in the passivation layer 34, as well to variations in the electric field distribution within the GaN transistor itself is reduced. Since the electrical field distribution between different devices is more uniform, the gate leakage and also the drain to gate and drain to source leakages are more uniform between different devices. Thus, the performance of the device and the uniformity of the performance between different devices is improved.

Additionally, screening of bad parts using PAT (Part Average Testing) techniques, which are used to detect and remove outlier devices, and a unified electrical screening procedure, which makes the detection of weak parts / defective parts becomes easier.

The relationship between the width wᵤ of the peripheral portion of the filed plate 17 and the thickness tₚ of the power metallic layer 18 may depend on the thickness of the power metallic layer 18. In an embodiment, 0.3 µm ≤ tₚ ≤ 5 µm and wᵤ ≥ 0.3tₚ. This range of thicknesses tₚ for the power metallic layer 18 may be used if the power metallic layer 18 is deposited using vacuum deposition techniques.

In an embodiment, 1.0 µm ≤ tₚ ≤ 7 µm and wᵤ ≥ 0.2tₚ. This range of thicknesses tₚ for the power metallic layer 18 may be used if the power metallic layer 18 is deposited using electroplating techniques.

The second power contact 15 has, in this embodiment, a similar structure to the first power electrode 14 and also includes an electrode 20, a field plate 21 on the electrode 20 and a power metallic layer 22 positioned directly on the field plate 21. The field plate 21 has a lateral extent in the first direction 19 which is greater than the lateral extent of the power metallic layer 22 in the direction 19. The field plate 21 of the second power contact 15 extends towards the first power contact 14 in a direction 19', which is parallel to the first major surface and which opposes the first direction 19, by a greater extent than the power metallic layer 22. The field plate 21 has a distal end portion that faces towards the first power contact 14 that is uncovered by the power metallic layer 22. The distal end portion of the field plate 21 also has a width w_{uc} that is uncovered by the power metallic layer 22. The thickness tₚ of the power metallic layer 22 and the thickness t_{fp} of the field plate 21 and the width w_{uc} may have the ranges and relationships described above in connection with the first power contact 14.

The field plate 17 has the form of the thin layer and is in direct contact with the metallic power layer 18. No additional via structure is provided which extends between the power metallic layer 18 and the thin layer providing the field plate 17. Similarly, the field plate 21 of the second power contact 15 has the form of the thin layer and is in direct contact with the second power metallic layer 22 and the arrangement includes no via between the thin layer providing the field plate 22 and the thicker power metallic layer 22.

In embodiments in which the first power contact 14 includes only a single field plate 17, the field plate 17 is in direct contact with the electrode 16 and with the power metallic layer 18 at a lateral location above the electrode 16. In embodiments in which the second power contact 15 includes only a single field plate 21, the field plate 21 is in direct contact with the electrode 20 and in direct contact with the power metallic layer 22 at a lateral location above the electrode 20 to form a stack.

In some embodiments, each of the first and second power contacts 14, 15 has an elongate stripe -like structure with a longest direction that extends parallel to the first major surface 12 and perpendicular to the first direction 19. In the cross-sectional view illustrated in figure 1, the longest direction of the first and second power contacts 14, 15 extends into the plane of the drawing. Consequently, the electrode 16, field plate 17 and power metallic layer 18 of the first power contact 14 also have an elongate stripe -like structure with the longest direction extending into the plane of the drawing and the electrode 20, field plate 21 and power metallic layer 22 of the second power contact 15 have an elongate stripe -like structure with the longest direction extending into the plane of the drawing.

The field plate 17 and power metallic layer 18 may be considered to form a stacked two-layer field plate. Similarly, the field plate 21 and power metallic layer 22 may be considered to form a stacked two-layer field plate. The structure of the first and second power contacts 14, 15 may be used in different type of semiconductor device.

In some embodiments not falling under the scope of the claims, the Group III nitride-based device 13 may be a diode and the first power contact 14 provide the anode and the second power contact 15 provides the cathode of the diode. In some embodiments, the first and second power contacts 14, 15 provide the power contacts of a bidirectional switch. The bidirectional switch further includes one or two gate electrodes that are arranged between the first and second power contacts 14, 15 in the first direction 19. The one or two gate electrodes of the bidirectional switch may have the structure of the gate 24 and arrangement with respect to the further features of the device described with reference to figure 1 below.

As illustrated in figure 1, the semiconductor device is a transistor device, for example a HEMT, and the first power contact 14 provides the source contact and the second power contact 15 provides the drain contact of the Group III nitride-based transistor device.

As illustrated in figure 1, the Group III nitride transistor device 13 further comprises a gate electrode 24 which is arranged on or in the first major surface 12 of the Group III nitride-based substrate 11. The gate electrode 24 is arranged laterally between the electrode 16 of the source power contact 14 and the electrode 20 of the drain power contact 15.

The drain-sided edge of the field plate 17 is closer to the second power contact 15 in the first direction 19 than the drain-sided edge of the power metallic layer 18 which is in turn closer to the second power contact 15 than the drain-sided edge of the electrode 16. Similarly, the gate-sided edge of the field plate 21 is closer to the first power contact 14 than the gate-sided edge of the power metallic layer 22 which is in turn closer to the first power contact 14 than the gate-sided edge of the electrode 20. The first and second power contacts 14, 15 are in direct contact with the barrier layer 28. The gate electrode 24 has a structure including a p doped Group IIII III nitride layer 31, for example p doped gallium nitride, and a gate metal layer 32 which is arranged on the p-doped Group IIII nitride layer 31. This structure for the gate 24 provides an enhancement mode device which is normally off. In other embodiments, the gate electrode 24 may have a recessed structure to provide an enhancement mode device. In some embodiments, such as that illustrated in figure 1, the gate electrode 24 has a recessed structure and has a p-doped Group III nitride layer 31 that lines or fills the recess 33. The gate metal layer 32 is arranged on the p-doped Group III nitride layer 31. In other embodiments, the gate electrode 24 may be without a p-doped Group III nitride region and without a recess and the transistor device is a depletion mode device.

The semiconductor device 10 comprises a passivation layer 34 which is positioned on the first major surface 12 and which extends over and covers the gate 24 and extends between the electrodes 16, 20 of the first and second power contacts 14, 15, respectively. The passivation layer 34 may also be positioned on peripheral regions of the electrode 16, 20 and leave the central region of the electrodes 16, 20 uncovered. The passivation layer 34 is arranged on the first major surface 12 between the electrode 16 of the first power contact 14 and the gate electrode 24.

The field plate 17 is positioned directly on the electrode 16 and extends over the passivation layer 34 such that it extends over and is electrically insulated from the gate 24 by the intervening passivation layer 34. The field plate 17 may be conformally deposited onto the passivation layer 34. The passivation layer 34 may comprise two or more sublayers which may have differing compositions.

The passivation layer 34 may be conformally deposited onto the gate electrode 14 and first major surface 12 and the field plate 17 may be conformally deposited onto the passivation layer 34 such that the field plate 17 includes a central raised portion above the gate electrode 24 and a substantially planar distal end portion positioned on the planar portion of the passivation layer 34. The substantially planar distal end portion of the field plate 17 is spaced apart from the drain sided edge of the gate 24 by the intervening conformally deposited passivation layer 34. The planar distal end portion of the field plate 17 is laterally between the drain-sided edge of the gate 24 and the electrode 20 of the second power contact 15 in the so-called access region. The passivation layer 34 may be formed of SiOₓ or SiNₓ or AlOx or AIN or a combination of two or more sublayers of these materials may be used to provide the passivation layer 34.

The power metallic layer 18 is positioned on the field plate 17 and has a lateral extent in the first direction 19 which is less than the lateral extent of the field plate 17 such that the distal end of the field plate 17 is uncovered by the power metallic layer 18. The distal end of the field plate 17 of the first power contact 14 is not in physical contact with the first power metallic layer 18. The power metallic layer 18 is also not in physical contact with the passivation layer 34. Similarly, the field plate 21 of the second power contact 15 extends over portion of the passivation layer 34 which is positioned on the peripheral region of the electrode 20 and the power metallic layer 22 is arranged on the field plate 21 such that the distal end of the field plate 21 is uncovered by the power metallic layer 22. The distal end of the field plate 21 of the second power contact 15 is not in physical contact with the power metallic layer 22. The power metallic layer 22 is not in physical contact with the passivation layer 34.

The power metallic layer 18, the distal end of the field plate 17 and the passivation layer 34 are covered by an insulating layer 35. The insulating layer 35 is arranged on the distal portion of the field plate 21 and also extends over the power metallic layer 22. The insulating layer35 is in direct contact with the distal end portions of the field plates 17, 21. The insulating layer 35 may comprise two or more sublayers which may have differing compositions, for example silicon nitride, SiNₓ, and silicon oxide. SiOₓ, or may comprise the same composition, for example silicon oxide, but be formed by different fabrication methods, for example TEOS and PVD.

In some embodiments, the Group III nitride-based substrate 11 comprises a multilayer structure. In some embodiments, the Group III nitride-based substrate 11 is arranged on a base substrate 25 which may be formed of a material other than a Group III nitride and be called a foreign substrate. For example, base substrate 25 may be formed of silicon and may be formed of monocrystalline silicon or an epitaxial silicon layer, for example. In another example the base substrate 25 is formed of sapphire. The base substrate 25 includes an upper or growth surface 30 which is capable of supporting the epitaxial growth of one or more Group III nitride-base layers. In some embodiments, the base substrate 25 is a foreign substrate, i.e. is formed of a material other than Group III nitride materials that includes the upper or growth which is capable of supporting the epitaxial growth of one or more Group III nitride layers. The Group III nitride-body or substrate 11 comprises a plurality of epitaxial Group III nitride layers.

The multilayer structure of the Group III nitride substrate 11 comprises a buffer structure 26 or seed layer on the base substrate 25, a GaN channel layer 27 on the buffer layer and an AlGaN barrier layer 28 on the GaN channel layer 27 which forms a heterojunction 29 therebetween which supports a two-dimensional charge gas such as a two-dimensional electron gas (2DEG). In this embodiment, the AlGaN barrier layer 28 forms the upper surface 12 of the Group IIII nitride substrate 11. This multilayer structure may be used for a HEMT, for example.

In some non-illustrated embodiments, the Group III nitride-based semiconductor substrate 11 may further include a back barrier layer. The channel layer 27 is formed on the back barrier layer and forms a heterojunction with the back barrier layer and the barrier layer 28 is formed on channel layer 27. The back barrier layer has a different bandgap to the channel layer 26 and may comprise AlGaN, for example. The composition of the AlGaN of the back barrier layer may differ from the composition of the AlGaN used for the barrier layer 28.

The buffer structure 26 may comprise one or more Group III nitrides and may comprises a plurality of sublayers. A typical transition or buffer structure 26 for a silicon substrate includes a AIN starting layer, which may have a thickness of several 100nm, on the silicon substrate followed by a AlₓGa₍₁₋ₓ₎N layer sequence, the thickness again being several 100nm's for each layer, whereby the Al content of about 50-75% is decreased down to 10-25% before the GaN layer or AlGaN back barrier, if present, is grown. Alternatively, a superlattice buffer can be used. Again, an AIN starting layer on the silicon substrate is used. Depending on the chosen superlattice, a sequence of AIN and AlₓGa₍₁₋ₓ₎N pairs is grown, where the thickness of the AIN layer and AlₓGa₍₁₋ₓ₎N is in the range of 2-25nm. Depending on the desired breakdown voltage the superlattice may include between 20 and 100 pairs. Alternatively, an AlₓGa₍₁₋ₓ₎N layer sequence as described above can be used in combination with the above mentioned superlattice.

In some embodiments, the drain contact has a so-called hybrid drain structure as illustrated in Fig. 1. The hybrid drain structure comprises the electrode 20, field plate 21 and metallic layer 22 having the arrangement described in connection with any one of the embodiments described herein and further comprises a p doped Group III nitride region 36 which is positioned on the first major surface 12 and which is electrically connected to the second power contact 15. The Group III nitride region 36 may be Mg-doped, for example a Mg-doped Group III nitride such as Mg-doped-GaN.

The p doped Group III nitride region 36 is positioned laterally in the first direction 19 between the gate 24 and the second electrode 20. In this embodiment, the second electrode 20 has a central planar or flat portion which is positioned in direct contact with the first major surface 12 of the Group III nitride substrate 11 and has a peripheral portion which extends upwardly from the first major 12 surface and onto the Group III nitride region 36. The peripheral region of the electrode 20 is in direct contact with the Group III nitride region 36. The gate sided edge of the p-doped Group III nitride region 36 and the gate sided edge of the second electrode 20 may be vertically aligned with one another. The passivation layer 34 extends over the periphery of the electrode 20 so as to cover the p doped Group III nitride region 36. The passivation layer 34 extends onto the periphery of planar portion of the second electrode 20 leaving the central portion of the planar portion uncovered.

In some embodiments, the p-doped Group III nitride region 36 has an elongate stripe -like structure having a longest direction which extends substantially parallel to the longest direction of the elongate strip-like electrode 20, the longest direction extending parallel to the first major surface 12 and perpendicular to the first direction 19. In some embodiments, the p doped Group III nitride region 36 may be divided into a plurality of separate sections which are positioned at intervals in a row which extends substantially parallel to the second electrode 20.

The field plate 21 extends over the passivation layer 34 and its distal portion is arranged above the p-doped Group III nitride region 36 and is spaced apart from the underlying portion of the second electrode 20 and the p doped Group III nitride region 36 by the passivation layer 34. The gate sided edge of the field plate 21 may be substantially vertically aligned, that is aligned in a direction perpendicular to the first major surface 12, with the gate sided edge of the second electrode 20 and the gate sided edge of the p doped Group III nitride region 36. The gate sided edge of the second power metallic layer 22 is located above the field plate 21 such that the distal end portion having the width w_{uc} of the field plate 21 including the gate sided edge of the field plate 21 is uncovered by the second power metallic layer 22 and is in direct contact with the insulating layer 35. The gate sided edge of the second power metallic layer 22 may be positioned in the first direction 19 between the drain sided edge of the p doped Group III nitride region 36 and the planar central portion of the second electrode 20. In the embodiment of figure 1, the field plate 21 formed part of the hybrid drain structure along with the second electrode 20, the p-doped Group III nitride region 36 that is in contact with the second electrode 20 and the field plate layer 21 that is positioned between and electrically connected with the second electrode 20 and second power metallic layer 22. In the embodiment of figure 1, the gate-sided edge of the field plate 21 is vertically aligned with the gate-sided edge of the p doped Group III nitride region 36. In some embodiments, the field plate 21 extends over the p doped Group III nitride region 36 such that the gate-sided edge of the field plate 21 is positioned at a shorter distance from the gate than the gate-sided edge of the p doped Group III nitride region 36.

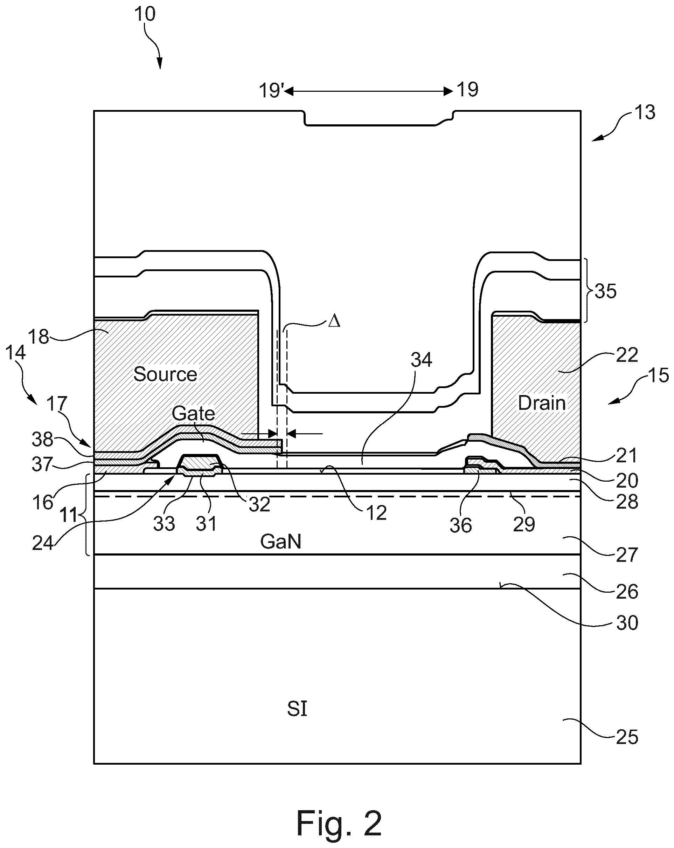

Figure 2 illustrates a semiconductor device 10 according to an embodiment. The semiconductor device 10 differs from that illustrated in figure 1 in the structure of the first power contact 14 and, in particular, in the structure of the first field plate 17 of the first power contact 14. In this embodiment, the field plate 17 comprises two sublayers 37, 38 which have same lateral extent but differing compositions. The lower sublayer 37 is formed of titanium and the upper sublayer 38 is formed of titanium nitride. The composition of the sublayers 37, 38 may be selected depending on the material of the electrode 16, power metallic layer 18 and/or passivation layer 34 and insulating layer 35. For example, the composition of the sublayers 37, 38 may be selected so as to provide an improved adhesion between the lower sublayer 37 of the field plate 17 and the electrode 16 and upper sublayer 38 of the field pale 17 and the power metallic layer 18 and/or with the passivation layer 34 and insulating 35 which are in contact with the distal end of the first sublayer 37 and second sublayer 38, respectively.

The use of two sublayers for the field plate 21 may also be used for the second power contact 15 in addition to the first power contact 14. In some embodiments, only the second power contact comprises two sublayers for the field plate 21 and the field plate 17 of the first contact 14 is formed of a single layer. The use of two sublayers for the both power contacts 14, 15 simplifies processing as fewer masks are required.

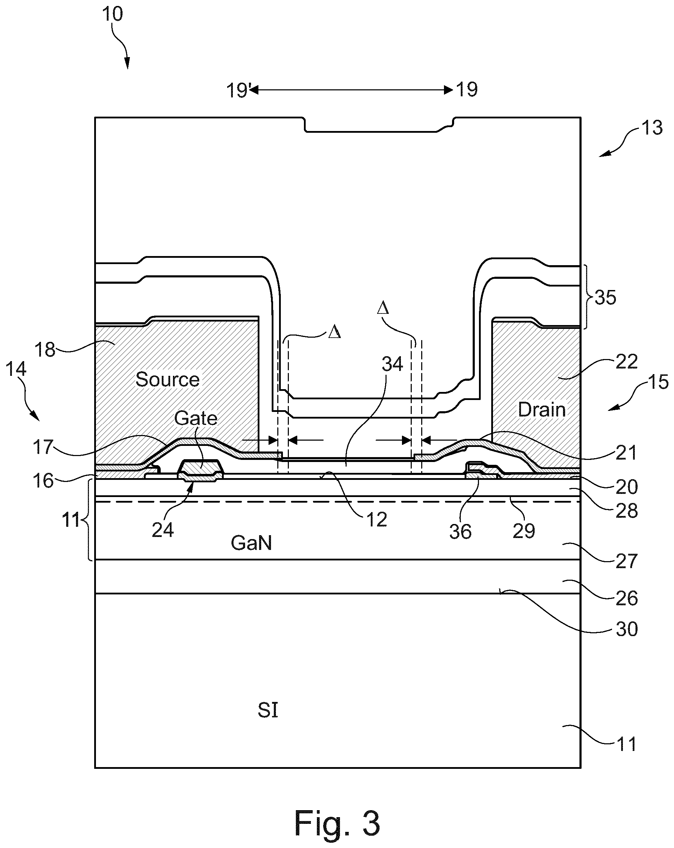

Figure 3 illustrates a semiconductor device 10 according to another embodiment. This embodiment differs from that illustrated in figure 1 in the shape of the second field plate 21 of the second power contact 15. In some embodiments, the second field plate 21 extends over the passivation layer 34 and over and beyond the p doped Group III nitride region 36 such that its gate sided edge is positioned closer to the gate than the gate-sided edge of the p doped Group III nitride region 36. In some embodiments, the second field plate 21 extends over the passivation layer 34 and over and beyond the p doped Group III nitride region 36 such that its distal end portion extends onto the planar region of the passivation layer 34 The distal end of the field plate 21 may be substantially planar. The distal end of the field plate 21 is arranged between the p-doped Group III nitride region 36 and the gate 24, i.e. in the access region. The width w_{uc} of the distal end portion of the field plate 21, which is uncovered by the second power metallic layer 22, is greater than that illustrated in figure 1. The gate sided edge of the field plate 21 of the second power contact 15 is, therefore, positioned closer to the drain sided edge of the field plate 17 of the first power contact 14 than in the embodiment illustrated in figure 1. In this embodiment, that the lateral extent of the field plates 17, 21 in the directions 19, 19' may be substantially the same, whereas the lateral extent in the direction 19' of the power metallic layer 22 is less than the width of the power metallic layer 18 in the first direction 19.

In figures 1 to 3, one or both of the first and second power contacts 14, 15 includes one field plate. In other embodiments, one or both of the first and second contacts 14, 15 includes two or more field plates.

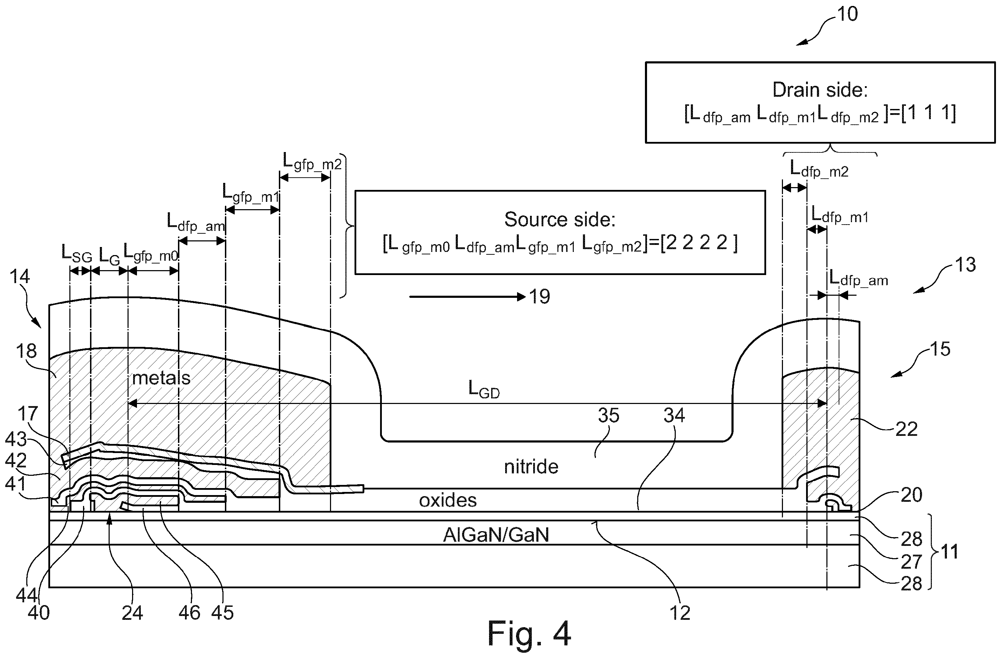

Figure 4 illustrates a semiconductor device 10 according to an embodiment in which the first power contact 14 includes three field plates. Two additional field plates are arranged between the first major surface 12 and the field plate 17 which are connected to source potential.

The first power contact 14 comprises a first field plate 44 which is in direct contact with the electrode 16 and which extends over the gate 24 and which is electrically insulated from the underlying gate 24 by a passivation layer 40. A second passivation layer 41 is arranged on the first field plate 44 and extends over the first field plate 44 and entirely covers the first field plate 44. A second field plate 42 is arranged on the second passivation layer 41 which may be in direct contact with the portion of the first field plate 44 arranged on the electrode 16 and which extends over the second passivation layer 41. The width of the second field plate 42 is greater than the width of the first field plate 44 such that the drain sided edge of the second field plate 42 is positioned at a shorter distance in the direction 19 from the gate sided edge of the power metallic layer 22 of the second power contact 15 than the drain sided edge of the first field plate 44. A third passivation layer 43 is arranged on and entirely covers the second field plate 42.

The field plate 17 is arranged on the third passivation layer 43 and the power metallic layer 18 is arranged on the field plate 17. The field plate 17 extends beyond the drain sided edge of the power metallic layer 18, similar to the arrangement of the two layer field plate 17, 18 shown in figures 1 to 3. The power metallic layer 18 may have a width which is greater than the width of the underlying first and second field plates 44, 42 such that the drain sided edge of the first metallic layer 18 is positioned at a smaller distance in the first direction 19 from the gate sided edge of the metallic layer 22 of the second power contact 15 than the drain sided edge of the field plates 42, 44. The drain sided edge of the first metallic layer 18 is positioned at a greater distance in the first direction 19 from the gate sided edge of the metallic layer 22 of the second power contact 15 than the drain sided edge of the field plates 17 so that the distal portion of the field plate 17 is uncovered by the power metallic layer 18 and in direct contact with the insulating layer 35. Each of the field plates 44, 42, 17 are electrically connected to the potential of the electrode 16, which in the illustrated embodiment is source potential. The width of the field plates 44, 42, 17 increases in the vertical direction so that the drain-sided edge of the field plate 42 is arranged at a greater distance from the drain sided edge of the gate electrode 24 than the drain-sided edge of the lowermost filed plate 44 and the drain-sided edge of the uppermost field plate 17 is arranged at a greater distance from the drain sided edge of the gate electrode 24 than the drain-sided edge of the intermediate filed plate 42.

In some embodiments, such as that illustrated in figure 4, the gate 24 also includes a field plate 45 which is electrically connected to gate potential. The field plate 45 may be integral with the gate metal 32 and extends in the first direction 19 towards the second power contact 15. The extension of the gate metal 32 which provides the field plate 45 is spaced apart from the first major surface 12 by a passivation layer46. The first passivation layer 40 which extends over the gate 24 also extends over the field plate 45 such the field plate 45 is entirely covered by the first passivation layer 40.

In the embodiment illustrated in figure 4, the lower field plates 44, 42 are formed of a single layer. The uppermost field plate 17 extends beyond the drain sided edge of the upper based metallic layer 18. The field plate 17 and power metallic layer 18 can be considered as a two layer structure which provides a field plate in which the lower layer of the two layer structure, that is the field plate layer 17, extends in the first direction 19 beyond the edge of the upper layer of the two layer structure, that is beyond the drain sided edge of the power metallic layer 18. The field plate 17 has a thickness than is less than the thickness of the power metallic layer 18. The field plate structure provided by the field plate 17 and power metallic layer 18 can have the arrangement, composition and dimensions of any one of the embodiments described with reference to figures 1 and 2.

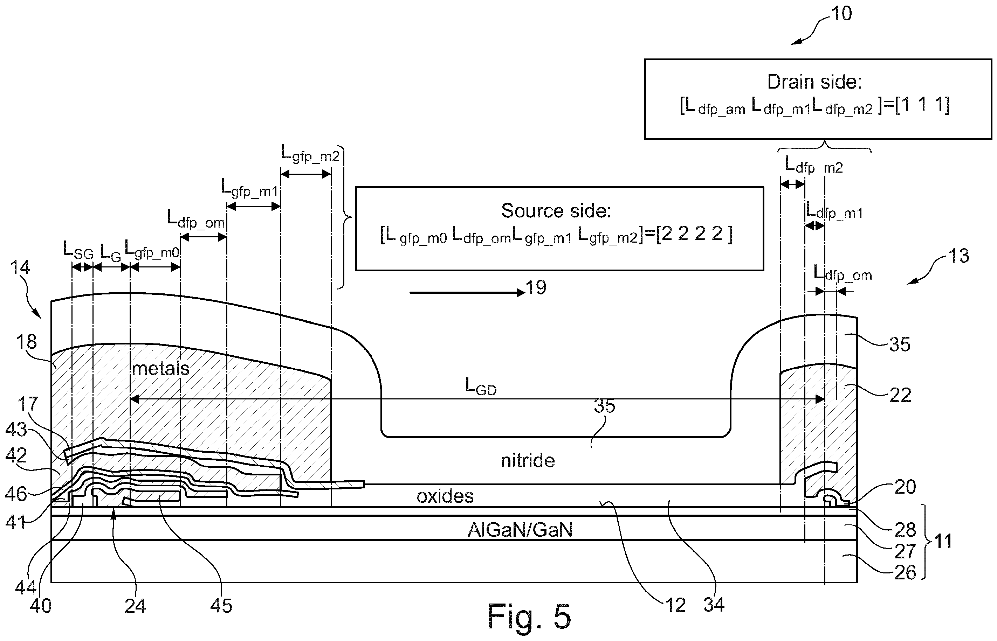

Figure 5 illustrates a semiconductor device 10 according to an embodiment which differs from that illustrated in figure 4 in that two of the field plates have a two layer structure, namely the upper most two-layer field plate 17, 18 and the adjacent filed plate 42 of the stack. As in the embodiment illustrated in figure 4, the uppermost field plate is formed by the field plate 17 and overlying power metallic layer 18. In addition, the underlying field plate 42 comprises a further thinner layer 46 which is positioned on the underlying oxide layer 41 and the thicker metal layer 42 is arranged on the thinner layer 46 so that the layers 46, 42 provide a two-layer field plate structure. The thinner layer 46 extends beyond the drain sided edge of the upper layer 42 of the two layer stack, that is beyond the drain sided edge of the field plate 42. These thinner layers 17, 46 of each of the two layer stacks may be formed of a different material to the other layer of the respective stack. For example, the field plates 18, 42 may be formed of copper or aluminium copper alloy and the thinner layers 17, 46 may be formed of titanium or titanium nitride.

To summarize, a semiconductor device is provided, in which at least one of the power contacts 14, 15 includes a field plate 17 which extends laterally beyond the laterally extend of the power metallic layer 18 of the power contact 14 to provide a field plate 17. This field plate 17 is thinner than the power metallic layer 18 and has an edge, whose position can be more accurately controlled reducing variations in the distance between the edge and another feature of the device, for example the gate 24. This enables the variation in the electric fields within the dielectrics located below the field plate 17, e.g. in the passivation layer 34, and passivation layers 40, 41 and passivation layer 43, if present, as well to the variation in the electric field distribution within the device, e.g. in the barrier layer 28 and channel layer 26 of the Group III nitride substrate 11 to be reduced. Since the electrical field distribution between different devices is more uniform, the gate leakage and the drain leakage in blocking state is more uniform between different devices.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described. Therefore, it is intended that this invention be limited only by the

## Claims

1. A semiconductor device (10) comprising:
a Group III nitride-based substrate (11) having a first major surface (12);
a lateral Group III nitride-based device (13) formed in the Group III nitride-based substrate (11);
a first power contact (14) and a second power contact (15) arranged on the first major surface (12);
a gate electrode (24);
wherein at least one of the first power contact (14) and the second power contact (15) comprise:
an electrode (16) arranged on the first major surface (12);
a field plate (17) arranged on the electrode (16) and having a lateral extent in a first direction parallel to the first major surface (12) that is greater than a lateral extent of the electrode (16) in the first direction;
a power metallic layer (18) arranged directly on the field plate (17), the power metallic layer (18) having a lateral extent in the first direction that is less than the lateral extent of the field plate (17) in the first direction,
wherein the power metallic layer (18) has a thickness tₚ,
wherein a peripheral portion of the field plate (17) has a width wᵤ that is uncovered by the power metallic layer (18),
wherein at least the peripheral portion of the field plate (17) with the width wᵤ extends beyond a lateral extent of the gate electrode (24) in the first direction by a distance I₁, wherein I₁ > 0.1 tₚ, wherein the lateral Group III nitride-based device is a transistor device and the first power contact provides the source contact and the second power contact provides the drain contact of the transistor device, wherein the gate electrode is arranged laterally between the source contact and the drain contact,
**characterized in that** the power metallic layer (18) extends beyond the lateral extent of the gate electrode (24) in the first direction by a distance I₂, wherein I₂ < I₁.

2. A semiconductor device (10) according to claim 1, wherein the first direction extends between the first and second power contacts (14, 15) and a distal end of the field plate (17) is arranged laterally between and is spaced apart from both the first power contact (14) and the second power contact (15).

3. A semiconductor device (10) according to claim 1 or claim 2, wherein wherein 0.3 µm ≤ tₚ ≤ 4 µm and wherein wᵤ ≥ 0.2tₚ and/or the field plate (17) has a thickness t_{fp} and 10 nm ≤ t_{fp} ≤ 500 nm.

4. A semiconductor device (10) according to claim 3, wherein wᵤ ≥ 0.3tₚ,

5. A semiconductor device (10) according to claim 3 or claim 4, wherein 10 nm ≤ t_{fp} ≤ 300 nm.

6. A semiconductor device (10) according to any one of claims 1 to 5, wherein an electrically insulating layer (35) is arranged on a peripheral portion of the field plate (17), the peripheral portion being located between the first and second power contacts (14, 15).

7. A semiconductor device (10) according to claim 6, wherein the electrically insulating layer (35) comprises at least two sublayers.

8. A semiconductor device (10) according to any one of claims 1 to 7, wherein the lateral Group III nitride-based device (13) is a bidirectional switch and one or more gate electrodes (24) are arranged laterally between the first power contact and the second power contact (14, 15).

9. A semiconductor device (10) according to claim 8, wherein the field plate (17) extends over and above the gate electrode (24) and is electrically insulated from the gate electrode (24) by a first passivation layer (34).

10. A semiconductor device (10) according to claim 1, wherein. l₁ ≥ 0.5 tₚ

11. A semiconductor device (10) according to any one of claims 8 to 10, wherein the gate electrode (24) comprises a p-doped Group III nitride region (31) and a metal layer (32) arranged on the p-doped Group III nitride region (31).

12. A semiconductor device (10) according to any one of claims 1 to 11, wherein one or both of the first and second power contacts (14, 15) comprises at least one further field plate (42, 44) arranged between the field plate (17) and the electrode (16), wherein the field plate (17) is in direct contact with the power metallic layer (18) and at least one of the further field plates (44) is in contact with the electrode (16).

13. A semiconductor device (10) according to any one of claims 1 to 12, wherein the power metallic layer (18) comprises Cu or Au or Alu.

14. A semiconductor device (10) according to any one of claims 1 to 13, wherein the Group III nitride-based substrate (11) comprises a Group III nitride channel layer (27) and a Group III nitride barrier layer (28) arranged on the Group III nitride channel layer (27) and forming a heterojunction (29) therebetween that is capable of supporting a two dimensional charge gas.

15. A semiconductor device (10) according to any one of claims 1 to 14, wherein the Group III nitride-based device (10) further comprises a p-doped Group III nitride region (36) that is coupled to the second power contact (15) and the field plate (21) that is electrically connected to the second power contact (15) extends beyond the p-doped Group III nitride region (36) that is coupled to the second power contact (15).

## Patentansprüche

1. Halbleitervorrichtung (10), umfassend:
ein nitridbasiertes Substrat (11) der Gruppe III mit einer ersten Hauptfläche (12);
eine laterale nitridbasierte Vorrichtung (13) der Gruppe III, die in dem nitridbasierten Substrat (11) der Gruppe III gebildet ist;
einen ersten Leistungskontakt (14) und einen zweiten Leistungskontakt (15), die auf der ersten Hauptfläche (12) angeordnet sind;
eine Gate-Elektrode (24);
wobei der erste Leistungskontakt (14) und/oder der zweite Leistungskontakt (15) Folgendes umfassen:
eine Elektrode (16), die auf der ersten Hauptfläche (12) angeordnet ist;
eine Feldplatte (17), die auf der Elektrode (16) angeordnet ist und eine laterale Erstreckung in einer ersten Richtung parallel zur ersten Hauptfläche (12) aufweist, die größer als eine laterale Erstreckung der Elektrode (16) in der ersten Richtung ist;
eine Leistungsmetallschicht (18), die direkt auf der Feldplatte (17) angeordnet ist, wobei die Leistungsmetallschicht (18) eine laterale Erstreckung in der ersten Richtung aufweist, die geringer als die laterale Erstreckung der Feldplatte (17) in der ersten Richtung ist,
wobei die Leistungsmetallschicht (18) eine Dicke tₚ aufweist,
wobei ein Peripherieteil der Feldplatte (17) eine Breite wᵤ aufweist, die nicht von der Leistungsmetallschicht (18) bedeckt ist,
wobei sich mindestens der Peripherieteil der Feldplatte (17) mit der Breite wᵤ in der ersten Richtung um eine Strecke l₁ über eine laterale Erstreckung der Gate-Elektrode (24) hinaus erstreckt, wobei l₁ > 0,1 tₚ, wobei die laterale nitridbasierte Vorrichtung der Gruppe III eine Transistorvorrichtung ist und der erste Leistungskontakt den Source-Kontakt bereitstellt und der zweite Leistungskontakt den Drain-Kontakt der Transistorvorrichtung bereitstellt, wobei die Gate-Elektrode lateral zwischen dem Source-Kontakt und dem Drain-Kontakt angeordnet ist,
**dadurch gekennzeichnet, dass**
sich die Leistungsmetallschicht (18) in der ersten Richtung um eine Strecke l₂ über die laterale Erstreckung der Gate-Elektrode (24) hinaus erstreckt, wobei l₂ < l₁.

2. Halbleitervorrichtung (10) nach Anspruch 1, wobei die erste Richtung zwischen dem ersten und dem zweiten Leistungskontakt (14, 15) verläuft und ein distales Ende der Feldplatte (17) lateral zwischen dem ersten Leistungskontakt (14) und dem zweiten Leistungskontakt (15) angeordnet ist und von diesen beabstandet ist.

3. Halbleitervorrichtung (10) nach Anspruch 1 oder Anspruch 2,
wobei 0,3 µm ≤ tₚ ≤ 4 µm und wobei wᵤ ≥ 0,2tₚ und/oder die Feldplatte (17) eine Dicke t_{fp} und 10 nm ≤ t_{fp} ≤ 500 nm aufweist.

4. Halbleitervorrichtung (10) nach Anspruch 3, wobei wᵤ ≥ 0,3tₚ.

5. Halbleitervorrichtung (10) nach Anspruch 3 oder Anspruch 4, wobei 10 nm ≤ t_{fp} ≤ 300 nm.

6. Halbleitervorrichtung (10) nach einem der Ansprüche 1 bis 5, wobei eine elektrisch isolierende Schicht (35) auf einem Peripherieteil der Feldplatte (17) angeordnet ist, wobei sich der Peripherieteil zwischen dem ersten und dem zweiten Leistungskontakt (14, 15) befindet.

7. Halbleitervorrichtung (10) nach Anspruch 6, wobei die elektrisch isolierende Schicht (35) mindestens zwei Unterschichten umfasst.

8. Halbleitervorrichtung (10) nach einem der Ansprüche 1 bis 7, wobei die laterale nitridbasierte Vorrichtung (13) der Gruppe III ein bidirektionaler Schalter ist und eine oder mehrere Gate-Elektroden (24) lateral zwischen dem ersten Leistungskontakt und dem zweiten Leistungskontakt (14, 15) angeordnet sind.

9. Halbleitervorrichtung (10) nach Anspruch 8, wobei sich die Feldplatte (17) über und oberhalb der Gate-Elektrode (24) erstreckt und durch eine erste Passivierungsschicht (34) von der Gate-Elektrode (24) elektrisch isoliert ist.

10. Halbleitervorrichtung (10) nach Anspruch 1, wobei l₁ ≥ 0,5tₚ.

11. Halbleitervorrichtung (10) nach einem der Ansprüche 8 bis 10, wobei die Gate-Elektrode (24) ein p-dotiertes Nitridgebiet (31) der Gruppe III und eine Metallschicht (32), die auf dem p-dotierten Nitridgebiet (31) der Gruppe III angeordnet ist, umfasst.

12. Halbleitervorrichtung (10) nach einem der Ansprüche 1 bis 11, wobei einer oder beide von dem ersten und dem zweiten Leistungskontakt (14, 15) mindestens eine weitere Feldplatte (42, 44) umfasst bzw. umfassen, die zwischen der Feldplatte (17) und der Elektrode (16) angeordnet ist, wobei die Feldplatte (17) mit der Leistungsmetallschicht (18) in direktem Kontakt steht und mindestens eine der weiteren Feldplatten (44) mit der Elektrode (16) in Kontakt steht.

13. Halbleitervorrichtung (10) nach einem der Ansprüche 1 bis 12, wobei die Leistungsmetallschicht (18) Cu oder Au oder Al umfasst.

14. Halbleitervorrichtung (10) nach einem der Ansprüche 1 bis 13, wobei das nitridbasierte Substrat (11) der Gruppe III eine Nitrid-Kanalschicht (27) der Gruppe III und eine Nitrid-Barriereschicht (28) der Gruppe III umfasst, die auf der Nitrid-Kanalschicht (27) der Gruppe III angeordnet ist und einen Heteroübergang (29) dazwischen bildet, der in der Lage ist, ein zweidimensionales Ladungsgas zu unterstützen.

15. Halbleitervorrichtung (10) nach einem der Ansprüche 1 bis 14, wobei die nitridbasierte Vorrichtung (10) der Gruppe III ferner ein p-dotiertes Nitridgebiet (36) der Gruppe III umfasst, das mit dem zweiten Leistungskontakt (15) gekoppelt ist, und sich die Feldplatte (21), die elektrisch mit dem zweiten Leistungskontakt (15) verbunden ist, über das p-dotierte Nitridgebiet (36) der Gruppe III, das mit dem zweiten Leistungskontakt (15) gekoppelt ist, hinaus erstreckt.

## Revendications

1. Un dispositif (10) à semiconducteur comprenant :
un substrat (11) à base de nitrure du groupe III ayant une première surface (12) principale ;
un dispositif (13) latéral à base de nitrure du groupe III formé dans le substrat (11) à base de nitrure du groupe III ;
un premier contact (14) de puissance et un deuxième contact (15) de puissance disposés sur la première surface (12) principale ;
une électrode (24) de grille ;
dans lequel au moins l'un du premier contact (14) de puissance et du deuxième contact (15) de puissance comprend :
une électrode (16) disposée sur la première surface (12) principale ;
une plaque (17) de champ disposée sur l'électrode (16) et ayant une étendue latérale dans une première direction parallèlement à la première surface (12) principale, qui est plus grande qu'une étendue latérale de l'électrode (16) dans la première direction ;
une couche (18) métallique de puissance disposée directement sur la plaque (17) de champ, la couche (18) métallique de puissance ayant une étendue latérale dans la première direction, qui est plus petite que l'étendue latérale de la plaque (17) de champ dans la première direction,
dans lequel la couche (18) métallique de puissance a une épaisseur tₚ,
dans lequel une partie périphérique de la plaque (17) de champ a une largeur wᵤ, qui n'est pas recouverte par la couche (18) métallique de puissance,
dans lequel au moins la partie périphérique de la plaque (17) de champ de largeur wᵤ s'étend au-delà d'une étendue latérale de l'électrode (24) de grille dans la première direction d'une distance I₁, dans lequel I₁ > 0,1 tₚ, dans lequel le dispositif latéral à base de nitrure du groupe III est un dispositif à transistor et le premier contact de puissance donne le contact de source et le deuxième contact de puissance donne le contact de drain du dispositif à transistor, dans lequel l'électrode de grille est montée latéralement entre le contact de source et le contact de drain,
**caractérisé en ce que**
la couche (18) métallique de puissance s'étend au-delà de l'étendue latérale de l'électrode (24) de grille dans la première direction d'une distance I₂, dans lequel I₂ < I₁.

2. Un dispositif (10) à semiconducteur suivant la revendication 1, dans lequel la première direction s'étend entre les premier et deuxième contacts (14, 15) de puissance et une extrémité distale de la plaque (17) de champ est disposée latéralement entre le premier contact (14) de puissance et le deuxième contact (15) de puissance et en étant à distance à la fois du premier contact (14) de puissance et du deuxième contact (15) de puissance.

3. Un dispositif (10) à semiconducteur suivant la revendication 1 ou la revendication 2, dans lequel $0 , 3 μm \leq {t}_{p} \leq 4$ µm et dans lequel wᵤ ≥ 0,2 tₚ et/ou la plaque (17) de champ a une épaisseur t_{fp} et 10 nm ≤ t_{fp} ≤ 500 nm.

4. Un dispositif (10) à semiconducteur suivant la revendication 3, dans lequel wᵤ ≥ 0,3 tₚ.

5. Un dispositif (10) à semiconducteur suivant la revendication 3 ou la revendication 4, dans lequel 10 nm ≤ t_{fp} ≤ 300 nm.

6. Un dispositif (10) à semiconducteur suivant l'une quelconque des revendications 1 à 5, dans lequel une couche (35) isolante électriquement est disposée sur une partie périphérique de la plaque (17) de champ, la partie périphérique étant disposée entre le premier et le deuxième contact (14, 15) de puissance.

7. Un dispositif (10) à semiconducteur suivant la revendication 6, dans lequel la couche (35) isolante électriquement comprend au moins deux sous-couches.

8. Un dispositif (10) à semiconducteur suivant l'une quelconque des revendications 1 à 7, dans lequel
le dispositif (13) latéral à base de nitrure du groupe III est un interrupteur bidirectionnel et une ou plusieurs électrodes (24) de grille sont montées latéralement entre le premier contact de puissance et le deuxième contact (14, 15) de puissance.

9. Un dispositif (10) à semiconducteur suivant la revendication 8, dans lequel la plaque (17) de champ s'étend sur et au-dessus de l'électrode (24) de grille et est isolée électriquement de l'électrode (24) de grille par une première couche (34) de passivation.

10. Un dispositif (10) à semiconducteur suivant la revendication 1, dans lequel I₁ ≥ 0,5 tₚ.

11. Un dispositif (10) à semiconducteur suivant l'une quelconque des revendications 8 à 10, dans lequel l'électrode (24) de grille comprend une région (31) de nitrure du groupe III à dopage p et une couche (32) métallique disposée sur la région (31) de nitrure du groupe III à dopage p.

12. Un dispositif (10) à semiconducteur suivant l'une quelconque des revendications 1 à 11, dans lequel l'une ou les deux du premier et du deuxième contacts (14, 15) de puissance comprend au moins une autre plaque (42, 44) de champ disposée entre la plaque (17) de champ et l'électrode (16), dans lequel la plaque (17) de champ est en contact direct avec la couche (18) métallique de puissance et au moins l'une des autres plaques (44) de champ est en contact avec l'électrode (16) .

13. Un dispositif (10) à semiconducteur suivant l'une quelconque des revendications 1 à 12, dans lequel la couche (18) métallique de puissance comprend du Cu ou de l'Au ou de l'Alu.

14. Un dispositif (10) à semiconducteur suivant l'une quelconque des revendications 1 à 13, dans lequel le substrat (11) à base de nitrure du groupe III comprend une couche (27) de canal de nitrure du groupe III et une couche (28) barrière de nitrure du groupe III disposée sur la couche (27) canal du groupe III et formant une hétérojonction (29) entre elles, qui est apte à supporter un gaz de charge à deux dimensions.

15. Un dispositif (10) à semiconducteur suivant l'une quelconque des revendications 1 à 14, dans lequel le dispositif (10) à base de nitrure du groupe III comprend en outre une région (36) de nitrure du groupe III à dopage p, qui est connectée au deuxième contact (15) de puissance et la plaque (21) de champ, qui est connectée électriquement au deuxième contact (15) de puissance, s'étend au-delà de la région (36) de nitrure du groupe III à dopage p, qui est connectée au deuxième contact (15) de puissance.
